# EUROPÄISCHE PATENTSCHRIFT

(11) **EP 3 127 234 B1**
(45) Veröffentlichungstag und Bekanntmachung des Hinweises auf die Patenterteilung: **25.03.2020**
(21) Anmeldenummer: 15706428.8
(22) Anmeldetag: 19.02.2015
(51) Int. Cl.: H02P 29/00, H02K 11/00, H05K 7/20

(54) **TREIBERBAUGRUPPE**
DRIVER ASSEMBLY
MODULE D'EXCITATION

(30) Priorität: 31.03.2014 DE 102014205957
(43) Veröffentlichungstag der Anmeldung: 08.02.2017
(73) Patentinhaber: Lemförder Electronic GmbH, 32339 Espelkamp (DE)
(72) Erfinder: JAHN, Jorg, 32257 Bünde (DE); ERDMANN, Thomas, 32351 Stemwede (DE); PALIT, Ajoy, 28357 Bremen (DE)
(74) Vertreter: Riegel, Werner
(86) Internationale Anmeldenummer: PCT/EP2015/053466
(87) Internationale Veröffentlichungsnummer: WO 2015/149986

(56) Entgegenhaltungen:
- EP-A1- 2 695 795
- CN-A- 102 355 150
- CN-U- 203 120 363
- DE-A1- 10 252 315
- DE-A1- 10 306 227
- DE-A1-102004 013 719
- DE-A1-102005 032 965
- DE-A1-102009 034 050
- DE-A1-102010 017 514
- DE-A1-102011 000 235
- US-A1- 2006 002 054
- US-A1- 2011 273 122
- US-B1- 7 983 046

## Beschreibung

Die Erfindung betrifft eine Treiberbaugruppe. Insbesondere betrifft die Erfindung die Anordnung von Elementen der Treiberbaugruppe.

Ein Steuergerät, beispielsweise an Bord eines Kraftfahrzeugs, ist dazu eingerichtet, einen Strom oder eine Spannung bereitzustellen, um einen angeschlossenen Verbraucher zu steuern. Beispielsweise kann eine Dreiphasen-Wechselspannung bereitgestellt werden, um die Drehrichtung, das Drehmoment oder die Drehgeschwindigkeit eines angeschlossenen Synchronmotors zu steuern.

Eine Treiberbaugruppe umfasst mehrere Halbleiterschalter, um den benötigten Strom bzw. die benötigte Spannung für den Synchronmotor bereitzustellen. Die Halbleiterschalter arbeiten üblicherweise nicht verlustfrei, sodass Wärme von ihnen abgeführt werden muss. Um Zuleitungen zu den Halbleiterschaltern möglichst kurz und direkt zu führen und mittels eines gemeinsamen Kühlkörpers kühlen zu können, sind die Halbleiterschalter üblicherweise matrixförmig oder zufällig angeordnet. Im Betrieb erwärmen sich die Halbleiterschalter in Abhängigkeit ihrer Anordnung unterschiedlich stark gegenseitig, sodass sie unterschiedliche Temperaturen annehmen. Durch die unterschiedlichen Temperaturen können die Halbleiterschalter elektrisch unterschiedlich stark belastbar sein, sodass die elektrische Gesamtbelastbarkeit der Treiberbaugruppe reduziert sein kann. Die Halbleiterschalter können auch unterschiedlich stark bzw. schnell altern, sodass ihre Ausfallwahrscheinlichkeiten unterschiedlich sind. Die Ausfallwahrscheinlichkeit der gesamten Treiberbaugruppe kann dadurch erhöht sein. Außerdem können Zuleitungen zu den Halbleiterschaltern unterschiedlich lang sein, wodurch eine elektromagnetische Verträglichkeit (EMV), eine Impedanz oder ein Spannungsabfall im Bereich der Zuleitungen negativ beeinflusst sein kann.

Die deutsche Offenlegungsschrift DE10252315A1 offenbart eine Treiberbaugruppe, die zur Steuerung eines Elektromotors dient, und ein Stanzgitter aufweist, das dazu dient die Verbindungsleitungen, Halbleiterschalter und Phasenwicklungen des Elekt ronmotors elektrisch zu verbinden. Die Ausführung des Stanzgitters ist so, dass die Halbleiterschalter in zwei konzentrischen Kreisen angeordnet sind.

Die DE10306227 zeigt einen Umrichter mit neun kreisförmig angeordneten Halbleiterschaltern.

Es ist Aufgabe der vorliegenden Erfindung, eine verbesserte Treiberbaugruppe anzugeben. Die Erfindung löst diese Aufgabe mittels einer Treiberbaugruppe mit den Merkmalen des unabhängigen Anspruchs. Unteransprüche geben bevorzugte Ausführungsformen wieder.

Eine erfindungsgemäße Treiberbaugruppe umfasst eine vorbestimmte Anzahl Halbleiterschalter, wobei einer der Halbleiterschalter innerhalb einer Kreislinie und die restlichen Halbleiterschalter auf der Kreislinie angeordnet sind. Dadurch können sich die Halbleiterschalter im Betrieb im Wesentlichen gleichmäßig erwärmen. Vorzugsweise sind der eine Halbleiterschalter angrenzend zu einem Mittelpunkt eines Kreises und die restlichen Halbleiterschalter auf einer Kreislinie um den Mittelpunkt angeordnet. Dadurch kann die im Wesentlichen gleichmäßige Erwärmung der Halbleiterschalter weiter optimiert werden. Thermische Belastungen der Halbleiterschalter können im Wesentlichen gleich sein, sodass auch elektrische Belastbarkeiten der Halbleiterschalter gleich sein können. Eine elektrische Belastbarkeit der gesamten Treiberbaugruppe kann dadurch insgesamt erhöht sein. Alternativ dazu können die Halbleiterschalter bei gleicher Belastbarkeit schwächer dimensioniert werden. Durch die gleichen thermischen Belastungen können die Halbleiterschalter auch gleich stark oder gleich schnell altern, wodurch die elektrischen Belastbarkeiten über die Lebensdauer der Halbleiterschalter vergleichbar bleiben können. Die elektrische Belastbarkeit der Treiberbaugruppe kann dadurch auf lange Sicht stabil sein. Die langfristige Zuverlässigkeit der Treiberbaugruppe kann erhöht sein. Dies ist insbesondere bei der Ansteuerung eines sicherheitskritischen Elements, beispielsweise einer elektrischen Lenkhilfe an Bord eines Kraftfahrzeugs, von Vorteil.

Bevorzugterweise sind die auf der Kreislinie liegenden Halbleiterschalter gleichmäßig verteilt. Dazu können auf der Kreislinie benachbarte Halbleiterschalter jeweils den gleichen Winkel bezüglich des Mittelpunkts einschließen. Die Anordnung der Halbleiterschalter kann toleranzbehaftet sein, indem an der Oberfläche jedes Halbleiterschalters ein beliebiger Punkt gewählt wird, dessen Position auf der Kreislinie oder bezüglich der anderen Halbleiterschalter wie beschrieben eingehalten ist. In einer anderen Ausführungsform haben die Halbleiterschalter vergleichbare Bauformen und die Punkte an den Oberflächen der Halbleiterschalter werden vergleichbar gewählt. Beispielsweise kann der Punkt jeweils am geometrischen Mittelpunkt oder im Bereich der stärksten Erwärmung während des Betriebs gewählt sein.

Insbesondere dann, wenn der gewählte Punkt im Bereich der stärksten Erwärmung gewählt ist, kann eine rotatorische Ausrichtung der einzelnen Halbleiterschalter bezüglich der Wärmeverteilung beliebig gewählt sein. In einer anderen Ausführungsform können die einzelnen Halbleiterschalter auch bezüglich kleinster Abstände ihrer Umrisse aneinander ausgerichtet werden. Dies kann insbesondere dann vorteilhaft sein, wenn die Oberflächen der Halbleiterschalter relativ groß sind und sich eine Oberfläche im Betrieb relativ gleichmäßig erwärmt.

In einer weiteren Ausführungsform können Abstände der auf der Kreislinie liegenden Halbleiterschalter zum mittleren Halbleiterschalter gleich groß sein. Die Erwärmung des mittleren Halbleiterschalters, der potentiell am stärksten einem Wärmeeintrag durch die restlichen Halbleiterschalter ausgesetzt ist, kann dadurch verbessert kontrolliert werden. Gleichmäßige Temperaturen der Halbleiterschalter können so leichter erreicht werden.

In einer besonders bevorzugten Ausführungsform ist die Treiberbaugruppe zur Ansteuerung eines Dreiphasen-Synchronmotors eingerichtet. Dazu umfasst die Treiberbaugruppe drei Halbbrücken mit insgesamt neun Halbleiterschaltern. Jede Halbbrücke umfasst drei Halbleiterschalter, die als High-Side-Switch, Low-Side-Switch und Phasentrenner miteinander verschaltet sind. Dabei ist der Phasentrenner zur Verbindung eines Mittenabgriffs zwischen dem High-Side-Switch und dem Low-Side-Switch mit einem Phasenanschluss des Synchronmotors vorgesehen.

Dadurch kann eine kompakte und thermisch stabile Treiberbaugruppe zur Ansteuerung des Synchronmotors angegeben werden, die durch die zusätzlichen Phasentrenner eine verbesserte Steuerbarkeit aufweist. Insbesondere ist es möglich, den Synchronmotor mittels der Phasentrenner abzuschalten, wenn beispielsweise ein fehlerhafter Zustand erfasst wurde. Ein Synchronmotor in einem sicherheitsrelevanten oder sicherheitskritischen System kann dadurch verbessert in einen sicheren Zustand gebracht werden, in dem der Synchronmotor weder kurzgeschlossen noch stromdurchflossen ist. Beispielsweise kann der Synchronmotor zur Verstärkung oder Abschwächung einer fahrerbewirkten Lenkkraft in einem Kraftfahrzeug dienen. Wird der Synchronmotor mittels der Phasentrenner abgeschaltet, so kann die Lenkkraft weder verstärkt noch verringert werden. Ein vorbestimmtes Lenkverhalten des Kraftfahrzeugs kann dadurch auch im Fehlerfall sichergestellt sein.

Bevorzugterweise sind die drei Halbleiterschalter der Phasentrenner in einer Reihe angeordnet und auf der einen Seite der Reihe sind die drei High-Side-Switches und auf der anderen die drei Low-Side-Switches angeordnet. Dabei ist der in der Mitte liegende Halbleiterschalter zwangsläufig ein Phasentrenner. Die Symmetrie der Wärmeverteilung in der Treiberbaugruppe kann dadurch verbessert sein. Außerdem können elektrische Verbindungen zwischen den einzelnen Halbleiterschaltern leichter kreuzungsfrei geführt werden. Durch die verbesserte Führung der Verbindungen können eine elektromagnetische Verträglichkeit, eine Impedanz und ein Leitungswiderstand der Verbindungen verbessert bzw. aneinander angeglichen werden. Die Treiberbaugruppe kann dadurch präziser steuerbar oder weniger störungsanfällig sein.

Die Halbleiterschalter können oberflächenmontierbare Bauelemente mit gleichen Pinbelegungen sein. Die Leitungsführung zwischen den Halbleiterschaltern, insbesondere bei der zuletzt beschriebenen Anordnung, kann dadurch weiter erleichtert sein. Die elektrischen Verbindungen, die den durch die Phasen des Synchronmotors fließenden Strom führen, können erleichtert kreuzungsfrei in einer Ebene geführt werden. Ein passender Schaltungsträger für die Halbleiterschalter, beispielsweise eine Platine mit aufgebrachten Leiterbahnen, kann dadurch leichter planbar und herstellbar sein. Die Erwärmung des Schaltungsträgers kann zudem verbessert kontrollierbar sein.

Bevorzugterweise ist ein Kühlkörper zur Anlage an den Halbleiterschaltern vorgesehen. Der Kühlkörper kann insbesondere eine kreisförmige Grundfläche aufweisen, die in Anlage mit den einzelnen Halbleiterschaltern steht. Dadurch kann eine zylinderförmige Anordnung von gleichmäßig gekühlten Halbleiterschaltern entstehen, die von der Treiberbaugruppe umfasst ist. Der Kühlkörper kann so an den Halbleiterschaltern angebracht sein, dass die dadurch entstandene Einheit separat handhabbar ist, wodurch beispielsweise ein Montageprozess der Treiberbaugruppe in einem Steuergerät zur Ansteuerung des Synchronmotors erleichtert sein kann. Außerdem kann die runde Form des Kühlkörpers bzw. der Einheit mit einer zylindrischen Form des Synchronmotors korrespondieren, sodass verbessert eine platzsparende Anbringung der Einheit am Synchronmotor möglich ist.

In einer bevorzugten Ausführungsform umfasst der Kühlkörper einen Vorsprung zur Anlage an einem an der Oberfläche liegenden elektrischen Verbindungselement zwischen zwei Halbleiterschaltern. Im Fall des oben beschriebenen Schaltungsträgers kann beispielsweise eine Leiterbahn durch den Vorsprung kontaktiert sein. Der Vorsprung kann dazu beitragen, dass ein Wärmeeintrag von einem Halbleiterschalter zu einem anderen mittels des elektrischen Verbindungselements verringert oder kompensiert wird. Außerdem kann der Vorsprung zur verbesserten mechanischen Befestigung des Kühlkörpers an dem Schaltungsträger dienen.

Es ist besonders bevorzugt, dass mehrere Vorsprünge derart zwischen den Halbleiterschaltern vorgesehen sind, dass sich die Halbleiterschalter im Betrieb auf gleiche Temperaturen erwärmen. Die Dimensionierung und Positionierung der Vorsprünge kann beispielsweise mittels Berechnungen, einer Simulation oder Versuch und Irrtum bestimmt werden. Je größer das Volumen eines Vorsprungs ist, desto stärker ist seine Wärmeableitung, sodass zwei Halbleiterschalter, die mit einem an dem Vorsprung anliegenden Verbindungselement verbunden sind, verbessert thermisch voneinander isoliert werden können.

In einer weiteren Ausführungsform ist ferner eine Steuereinrichtung zur Ansteuerung der Halbbrücken vorgesehen. Die Steuereinrichtung ist dazu eingerichtet, Phasenspannungen oder Phasenströme des Synchronmotors zu überwachen und den Synchronmotor mittels der Phasentrenner auszuschalten, falls die bestimmten Phasenspannungen oder Phasenströme auf einen Defekt eines der High-Side-Switches oder eines der Low-Side-Switches hinweisen. Eine Baugruppe, die die Treiberbaugruppe, die Steuereinrichtung und den Synchronmotor umfasst, kann dadurch auch im Fehlerfall in einen sicheren Zustand gebracht werden. Dies kann insbesondere bei dem oben beschriebenen sicherheitsrelevanten System an Bord eines Kraftfahrzeugs, beispielsweise an der Lenkhilfe, vorteilhaft sein.

Die Erfindung wird nun mit Bezug auf die beigefügten Figuren genauer beschrieben, in denen:
- Figur 1: eine Anordnung von Halbleiterschaltern einer Treiberbaugruppe;
- Figur 2: ein Schaltbild einer Baugruppe mit der Treiberbaugruppe von Figur 1;
- Figur 3: eine Leitungsführung zwischen den Halbleiterschaltern der Treiberbaugruppe von Figur 1 und
- Figur 4: eine Seitenansicht einer Ausführungsform der Treiberbaugruppe von Figur 1
darstellt.

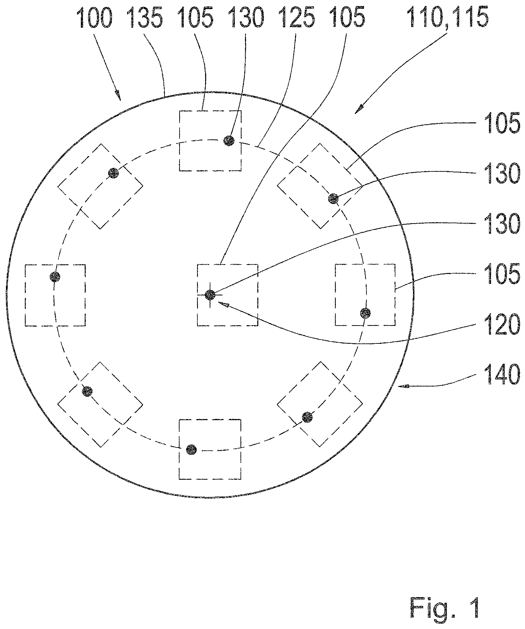

Figur 1 zeigt eine schematische Draufsicht auf eine Treiberbaugruppe 100 mit mehreren Halbleiterschaltern 105. Die Halbleiterschalter 105 sind bevorzugterweise oberflächenmontierbare Bauelemente, die in einer Ebene 110 angeordnet sind, die insbesondere durch die Oberfläche eines Schaltungsträgers 115, etwa einer Platine, gebildet ist. Die Halbleiterschalter können beispielsweise Bipolartransistoren, Feldeffekttransistoren, MOSFETs, Thyristoren, Schaltdioden oder IGBTs umfassen. In beispielhafter Weise sind die neun Halbleiterschalter 105 vorgesehen, deren elektrische Konfiguration unten noch genauer beschrieben wird. Einer der Halbleiterschalter 105 ist im Bereich eines Mittelpunkts 120 einer Kreislinie 125 angeordnet, während die restlichen Halbleiterschalter 105 auf der Kreislinie 125 liegen.

Zur Bestimmung der Position eines Halbleiterschalters 105 kann ein Punkt 130 innerhalb seines Umrisses gewählt sein, dessen exakte Position auf der Kreislinie 125 oder auf dem Mittelpunkt 120 bestimmt werden kann. Bevorzugterweise weisen die Halbleiterschalter 105 gleiche Umrisse auf und die Punkte 130 sind an korrespondierenden Stellen gewählt. Die Stellen können beispielsweise aufgrund von geometrischen oder thermischen Überlegungen, etwa an einem geometrischen Mittelpunkt oder an einem Punkt der stärksten Erwärmung, gewählt sein. In der Darstellung von Figur 1 sind die Punkte 130 an den Halbleiterschaltern korrespondierend aber außermittig gewählt. Dabei fällt der Punkt 130 des mittleren Halbleiterschalters 105 auf den Mittelpunkt 120. Die Punkte 130 der restlichen acht Halbleiterschalter 105 sind auf der Kreislinie 125 gleichmäßig verteilt, sodass benachbarte Punkte 130 bezüglich des Mittelpunkts 120 jeweils einen Winkel von 360° : 8 = 45° einschließen.

Bevorzugterweise sind die Halbleiterschalter 105 thermisch mit einem Kühlkörper 135 gekoppelt. Der Kühlkörper 135 weist bevorzugterweise eine runde Grundfläche 140 zur Anlage an Oberflächen der Halbleiterschalter 105 auf. In einer anderen Ausführungsform kann die Grundfläche 140 auch gleichmäßig polygonal mit so vielen Ecken sein, wie Halbleiterschalter 105 auf der Kreislinie 125 angeordnet sind. Dadurch kann die Treiberbaugruppe 100 eine im Wesentlichen zylindrische Form erhalten, die mit einer zylindrischen Form eines Endabschnitts eines Synchronmotors korrespondieren kann, der durch die Treiberbaugruppe 100 steuerbar ist. Die Treiberbaugruppe 100 kann im Bereich des Endabschnitts vorteilhaft platzsparend am Synchronmotor angeordnet werden. Insbesondere kann die Treiberbaugruppe 100 in axialer Verlängerung des Endabschnitts angeordnet sein, wodurch die Treiberbaugruppe 100 mit dem Synchronmotor eine separat handhabbare Einheit bilden kann. Der Synchronmotor und die Treiberbaugruppe 100 können in einem gemeinsamen Gehäuse angeordnet sein.

Der Kühlkörper 135 kann thermisch mittels eines Wärmeleitpads, einer Wärmeleitpaste oder einer Glimmerscheibe, verbessert angebunden sein. Dadurch kann eine elektrische Isolation der Halbleiterschalter 105 vom Kühlkörper 135 bewirkt sein, die insbesondere dann vorteilhaft ist, wenn ein elektrischer Anschluss eines Halbleiterschalters 105 an dessen Oberfläche liegt. Dies ist beispielsweise der Fall bei sogenannten DirectFETs, die als Halbleiterschalter 105 in der Treiberbaugruppe 100 bevorzugt verwendet werden.

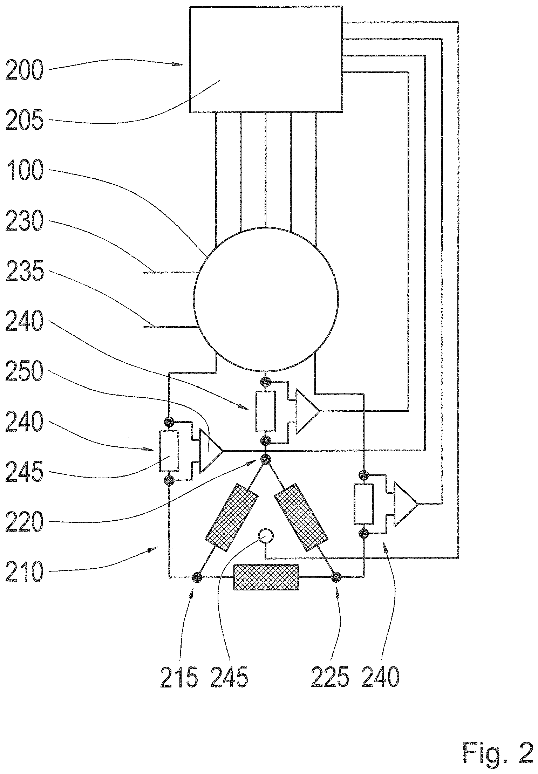

Figur 2 zeigt ein Steuergerät 200, insbesondere zum Betrieb an Bord eines Kraftfahrzeugs. Das Steuergerät 200 umfasst die Treiberbaugruppe 100 aus Figur 1 sowie eine Steuereinrichtung 205 und ist dazu eingerichtet, einen Dreiphasen-Synchronmotor 210 anzusteuern. Der Synchronmotor 210 kann insbesondere von einem Aktuator umfasst sein, der eine sicherheitsrelevante oder sicherheitskritische Funktion an Bord des Kraftfahrzeugs beeinflusst. Beispielsweise kann eine Lenkung des Kraftfahrzeugs einen elektrischen Lenkkraftverstärker umfassen, der durch den Synchronmotor 210 angetrieben wird. In anderen Ausführungsformen kann der Synchronmotor 210 auch für den Antrieb einer anderen Einrichtung an Bord des Kraftfahrzeugs vorgesehen sein, beispielsweise für einen Fensterheber, den Antrieb eines elektrischen Verdecks oder einer Sitzverstellung.

Der Synchronmotor 210 ist beispielhaft in Sternschaltung konfiguriert und umfasst drei Phasen 215 bis 225, die jeweils zur Verbindung mit einer Stromquelle oder Stromsenke eingerichtet sind, um eine Drehrichtung, eine Drehgeschwindigkeit oder ein Drehmoment des Synchronmotors 210 zu steuern. Im Folgenden wird der Begriff Phase allgemein für einen der drei elektrischen Anschlüsse des dargestellten Dreiphasen-Synchronmotors 210 verwendet.

Die drei Phasen 215 bis 225 sind mit dem Steuergerät 200 verbunden. Die Steuereinrichtung 205 ist dazu eingerichtet, die Treiberbaugruppe 100 derart anzusteuern, dass die einzelnen Phasen 215 bis 225 in definierter zeitlicher Abfolge derart mit einem positiven Potential 230 oder einem negativen Potential 235 verbunden werden, dass sich eine vorbestimmte Drehbewegung oder ein vorbestimmtes Drehmoment am Synchronmotor 210 einstellt.

Zusätzlich ist die Steuereinrichtung 205 bevorzugterweise dazu eingerichtet, einen Fehlerfall zu bestimmen und die Treiberbaugruppe 100 daraufhin abzustellen, sodass die drei Phasen 215 bis 225 weder untereinander noch mit einem der Potentiale 230 oder 235 verbunden sind.

Dazu kann an den Verbindungen zwischen den Phasen 215 bis 225 und der Treiberbaugruppe 100 jeweils ein Sensor 240 vorgesehen sein. Der Sensor 240 kann zur Bestimmung einer an der jeweiligen Phase 215 bis 225 anliegenden Spannung oder eines durch die jeweilige Phase 215 bis 225 fließenden Stroms eingerichtet sein. In einer weiteren Ausführungsform sind nur zwei Sensoren 240 vorgesehen und die Bestimmung eines korrespondierenden Messwerts für die verbleibende Phase 215 bis 225 erfolgt analytisch, insbesondere auf der Basis der Kirchhoff'schen Regeln.

In der vorliegenden Ausführungsform sind die Sensoren 240 zur Bestimmung von Phasenströmen eingerichtet. Ein Sensor 240 umfasst hierfür einen Längswiderstand 245, der auch Shunt genannt wird, und der von dem durch die jeweilige Phase 215 bis 225 fließenden Strom durchflossen wird. Eine über dem Längswiderstand 245 abfallende Spannung wird in der vorliegenden, beispielhaften Ausführungsform mittels eines Messverstärkers 250 bestimmt, sodass ein zum durch die Phase 215 bis 225 fließenden Strom proportionales Signal vorliegt. Dieses Signal wird bevorzugterweise von der Steuereinrichtung 205 ausgewertet.

Eine Fehlfunktion im Bereich der Treiberbaugruppe 100 kann beispielsweise dazu führen, dass eine der Phasen 215 bis 225 permanent mit dem positiven Potential 230 oder dem negativen Potential 235 verbunden ist. In diesem Fall könnte ein durch die entsprechende Phase 215 bis 225 fließender Strom auch ohne entsprechende Ansteuerung der Treiberbaugruppe 100 festgestellt werden. Diese Fehlfunktion kann auch durch Beobachten der Phasenspannungen detektiert werden.

In einer weiteren Ausführungsform kann ein Drehsensor 245 vorgesehen sein um die Drehbewegung des Synchronmotors 210 abzutasten. Der Drehsensor 245 kann mit der Steuereinrichtung 205 verbunden sein und die Steuereinrichtung 205 kann die zeitliche Abfolge der Phasenströme in Abhängigkeit des Drehsignals des Drehsensors 245 steuern. Außerdem kann mittels des Drehsensors 245 eine Fehlfunktion bestimmt werden, bei der sich der Synchronmotor 210 anders dreht als durch die Ansteuerung der Phasen 215 bis 225 zu erwarten wäre, beispielsweise weil er mechanisch blockiert ist und sich unabhängig von seiner Ansteuerung überhaupt nicht dreht.

Wird also eine Fehlfunktion festgestellt, so kann die Steuereinrichtung 205 die Treiberbaugruppe 100 abschalten. Bevorzugterweise sind hierfür in der Treiberbaugruppe 100 dedizierte Halbleiterschalter 105 vorgesehen, die dann angesteuert werden, eine elektrische Verbindung zwischen den Phasen 215 bis 225 und weiteren Halbleiterschaltern 105 der Treiberbaugruppe 100 zu unterbrechen, wie im Folgenden genauer beschrieben wird.

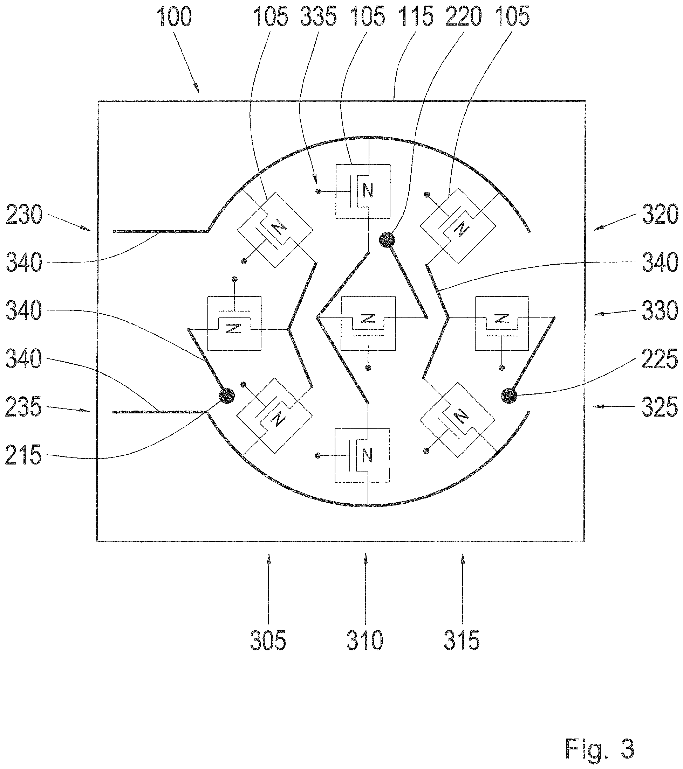

Figur 3 zeigt eine beispielhafte Leitungsführung zwischen den Halbleiterschaltern 105 der Treiberbaugruppe 100 von Figur 1 für das Steuergerät 200 von Figur 2. Dabei wird eine bevorzugte Anordnung der Halbleiterschalter 105 entsprechend der in Figur 1 dargestellten Ausführungsform verwendet. Gezeigt ist eine Draufsicht auf die Platine 115 ohne den Kühlkörper 135. Elektrische Verbindungen sind schematisch dargestellt.

In der dargestellten, bevorzugten Ausführungsform sind die neun Halbleiterschalter 105 in drei Halbbrücken 305 bis 315 organisiert. Jede Halbbrücke 305 bis 315 umfasst drei Halbleiterschalter 105, von denen einer als High-Side-Switch 320, einer als Low-Side-Switch 325 und einer als Phasentrenner 330 verwendet wird. Der Phasentrenner 330 einer Halbbrücke 305 bis 315 ist dazu eingerichtet, eine schaltbare Verbindung zu einer der Phasen 215 bis 225 herzustellen. Der Anschluss des Phasentrenners 330, der auf diese Weise schaltbar mit der jeweiligen Phase 215 bis 225 verbunden ist, ist mit einem Anschluss des High-Side-Switches 320 verbunden, um an das positive Potential 230 geschaltet zu werden, und einem Anschluss des Low-Side-Switches 325, um an das negative Potential 235 geschaltet zu werden. Dabei wird ein gleichzeitiges Schließen des High-Side-Switches 320 und des Low-Side-Switches 325 derselben Halbbrücke 305 bis 315 üblicherweise durch eine entsprechende Ansteuerung vermieden.

Die Halbleiterschalter 105 weisen bevorzugterweise die gleiche Pinbelegung auf. Dazu können die Halbleiterschalter 105 des gleichen Typs verwendet werden. In einer anderen Ausführungsform können die Halbleiterschalter 105 eines High-Side-Switches 320 und eines Low-Side-Switches 325 ein Komplementärpaar bilden, wobei spiegelverkehrte Pinbelegungen möglich sind.

Außerdem ist bevorzugt, dass die Halbleiterschalter 105 oberflächenmontierbar sind. In der Darstellung von Figur 3 sind die Halbleiterschalter auf einer Oberfläche des Schaltungsträgers 115 angebracht. Die Halbleiterschalter 105 können insbesondere Feldeffekttransistoren umfassen, die bevorzugterweise in der Bauform von DirectFETs verwendet werden.

Jeder der neun dargestellten Halbleiterschalter 105 ist bevorzugterweise separat ansteuerbar. An jedem Halbleiterschalter 105 ist ein Steueranschluss 335 vorgesehen, der mit der Steuereinrichtung 205 verbunden werden kann. Die anderen beiden Anschlüsse jedes Halbleiterschalters 105 werden mittels Verbindungselementen 340, die in Fig. 3 schematisch durch breite Linien dargestellt sind, elektrisch miteinander verbunden, wie oben beschrieben ist. Bevorzugterweise sind die Halbleiterschalter 105 derart bezüglich des Mittelpunkts 120 und der Kreislinie 125 (beide nicht dargestellt) angeordnet, dass die drei Phasentrenner 330 in einer Reihe bzw. auf einer geraden Linie liegen. Zwei der Phasentrenner 330 liegen dabei auch auf der Kreislinie 125 und der dritte Phasentrenner 330 liegt zwischen ihnen auf der Linie im Bereich des Mittelpunkts 120. Bevorzugterweise sind die High-Side-Switches 320 auf der einen Seite dieser Linie angeordnet, in Figur 3 auf der oberen Seite, während die Low-Side-Switches 325 auf der anderen Seite angeordnet sind, in Figur 3 auf der unteren Seite. Sowohl die High-Side-Switches 320 als auch die Low-Side-Switches 325 liegen dabei auf der Kreislinie 125.

Verbindungen zwischen den Halbleiterschaltern 105, zwischen den Halbleiterschaltern 105 und den Potentialen 230 und 235, und zwischen den Halbleiterschaltern 105 und Anschlüssen für die Phasen 215 bis 225 können, wie in Figur 3 gezeigt ist, leicht kreuzungsfrei und auch kurz gehalten sein. Verbindungen zwischen den Steueranschlüssen 335 und der Steuereinrichtung 205 können auf eine bekannte Weise leicht entflochten werden. In einer bevorzugten Ausführungsform werden alle elektrischen Verbindungen, die zu Steueranschlüssen 335 führen, in einer anderen Ebene geführt als die Verbindungselemente 340, die die Ströme führen, die durch die Phasen 215 bis 225 des Synchronmotors 210 fließen. Hierzu kann ein Schaltungsträger 115 mit mehreren Ebenen verwendet werden, auf denen die Verbindungselemente 340 geführt werden können. In der dargestellten Ausführungsform werden die stromführenden Verbindungselemente 340 auf der Oberseite des Schaltungsträgers 115 geführt, während Verbindungselemente zur Kontaktierung der Steueranschlüsse 335 mittels Durchkontaktierungen auf die Unterseite des Schaltungsträgers 115 verlegt werden können.

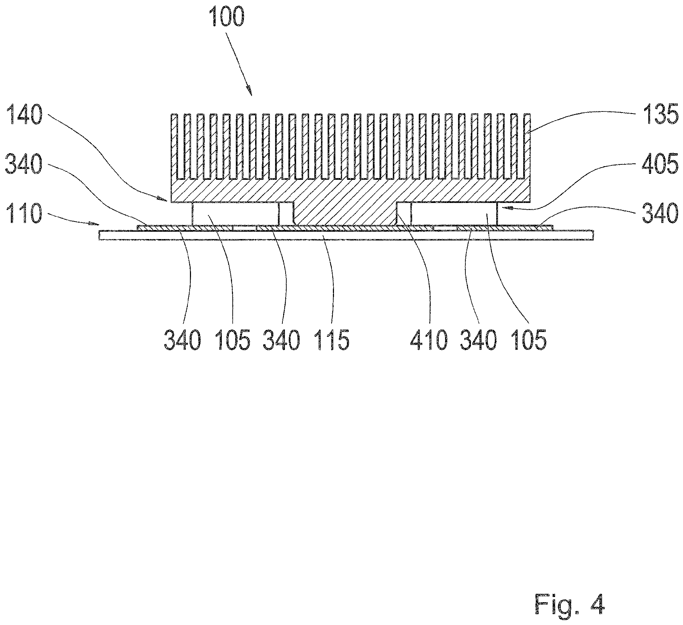

Figur 4 zeigt eine Seitenansicht einer Ausführungsform der Treiberbaugruppe 100 von Figur 1. Die Grundfläche 140 des Kühlkörpers 135 liegt an oberen Oberflächen der Halbleiterschalter 105 an. Bevorzugterweise erfolgt die thermische Kopplung des Kühlkörpers 135 mit den Halbleiterschaltern 105 mittels eines dazwischen eingefügten Wärmeleitmittels 405. Das Wärmeleitmittel 405 hat bevorzugterweise einen geringen Wärmewiderstand und ist bevorzugterweise dazu eingerichtet, unterschiedlich breite Spalte zwischen den oberen Oberflächen der Halbleiterschalter 105 und der Grundfläche 140 des Kühlkörpers 135 zu überbrücken. Dadurch können vertikale Montagetoleranzen der Halbleiterschalter 105 ausgeglichen werden. Ferner ist bevorzugt, dass das Wärmeleitmittel 405 elektrisch isolierend ist. Das Wärmeleitmittel 405 kann beispielsweise ein Wärmeleitpad, eine Wärmeleitpaste oder eine Glimmerscheibe umfassen.

Der Kühlkörper 135 kann einen Vorsprung 410 umfassen, der dazu eingerichtet ist, an einem Verbindungselement 340 anzuliegen. Zwischen dem Vorsprung 410 und dem Verbindungselement 340 kann ebenfalls ein Wärmeleitelement 405 vorgesehen sein. Vermittels des Vorsprungs 410 kann das Verbindungselement 340 verbessert gekühlt werden. Ein Wärmeeintrag entlang des Verbindungselements 340 in einen der Halbleiterschalter 105 kann dadurch reduziert werden. Insbesondere kann ein Verbindungselement 340, das zwei Halbleiterschalter 105 elektrisch miteinander verbindet, mittels des Vorsprungs 410 gekühlt werden. Dadurch kann eine thermische Isolation der beiden Halbleiterschalter 105 verbessert sein.

Eine Größe, Position und Form des Vorsprungs 410 kann so gewählt werden, dass ein Wärmefluss zwischen den Halbleiterschaltern 105 derart beeinflusst wird, dass die Halbleiterschalter 105 im Betrieb im Wesentlichen gleich erwärmt werden. Mehrere Vorsprünge 410 zwischen Paaren von Halbleiterschaltern 106 können vorgesehen sein, wobei die Vorsprünge 410 auch unterschiedlich geformt sein können. Größen und Formen der Vorsprünge 410 können so gewählt sein, dass eine gleichmäßige Erwärmung der Halbleiterschalter 105 im Betrieb gewährleistet ist.

Allgemein ist bevorzugt, dass sich Vorsprünge 410 nur zu den in Figur 3 mit breiten Linien dargestellten Verbindungselementen 340 erstrecken, die von Strömen durchflossen sind, die durch die Phasen 215 bis 225 des Synchronmotors 210 fließen.

### Bezugszeichen

- 100: Treiberbaugruppe
- 105: Halbleiterschalter
- 110: Ebene
- 115: Schaltungsträger (Platine)
- 120: Mittelpunkt
- 125: Kreislinie
- 130: Punkt
- 135: Kühlkörper
- 140: Grundfläche
- 200: Steuergerät
- 205: Steuereinrichtung
- 210: Dreiphasen-Synchronmotor
- 215: erste Phase
- 220: zweite Phase
- 225: dritte Phase
- 230: positives Potential
- 235: negatives Potential
- 240: Sensor
- 245: Längswiderstand (Shunt)
- 250: Messverstärker
- 305: erste Halbbrücke
- 310: zweite Halbbrücke
- 315: dritte Halbbrücke
- 320: High-Side-Switch
- 325: Low-Side-Switch
- 330: Phasentrenner
- 335: Steueranschluss
- 340: Verbindungselement
- 405: Wärmeleitmittel
- 410: Vorsprung

## Patentansprüche

1. Treiberbaugruppe (100), wobei die Treiberbaugruppe (100) folgendes umfasst:
eine vorbestimmte Anzahl Halbleiterschalter (105), wobei einer der Halbleiterschalter (105) innerhalb einer Kreislinie (125) und die restlichen Halbleiterschalter (105) auf der Kreislinie (125) angeordnet sind, **dadurch gekennzeichnet, dass** Abstände der auf der Kreislinie (125) liegenden Halbleiterschalter (105) zum mittleren Halbleiterschalter (105) gleich groß sind, und dass insgesamt neun Halbleiterschalter (105) vorgesehen sind, die Treiberbaugruppe (100) drei Halbbrücken (305, 310, 315) zur Ansteuerung eines Dreiphasen-Synchronmotors (210) umfasst und
- jede Halbbrücke (305, 310, 315) drei Halbleiterschalter (105) umfasst, die als High-Side-Switch (320), Low-Side-Switch (325) und Phasentrenner (330) miteinander verschaltet sind;
- wobei der Phasentrenner (330) zur Verbindung eines Mittenabgriffs zwischen dem High-Side-Switch (320) und dem Low-Side-Switch (325) mit einem Phasenanschluss (215, 220, 225) des Synchronmotors (210) vorgesehen ist.

2. Treiberbaugruppe (100) nach Anspruch 1, **dadurch gekennzeichnet, dass** die auf der Kreislinie (125) liegenden Halbleiterschalter (105) gleichmäßig verteilt sind.

3. Treiberbaugruppe (100) nach Anspruch 3, **dadurch gekennzeichnet, dass** die drei Halbleiterschalter (105) der Phasentrenner (330) in einer Reihe angeordnet sind und auf der einen Seite der Reihe die drei High-Side-Switches (320) und auf der anderen die drei Low-Side-Switches (325) angeordnet sind.

4. Treiberbaugruppe (100) nach einem der vorangehenden Ansprüche, **dadurch gekennzeichnet, dass** die Halbleiterschalter (105) oberflächenmontierbare Bauelemente mit gleichen Pinbelegungen sind.

5. Treiberbaugruppe (100) nach einem der vorangehenden Ansprüche, ferner umfassend einen Kühlkörper (135) zur Anlage an den Halbleiterschaltern (105).

6. Treiberbaugruppe (100) nach Ansprüchen 4 und 5, **dadurch gekennzeichnet, dass** der Kühlkörper (135) einen Vorsprung (410) zur Anlage an einem an der Oberfläche liegenden elektrischen Verbindungselement (340) zwischen zwei Halbleiterschaltern (105) umfasst.

7. Treiberbaugruppe (100) nach Anspruch 6, **dadurch gekennzeichnet, dass** mehrere Vorsprünge (410) derart zwischen den Halbleiterschaltern (105) vorgesehen sind, dass sich die Halbleiterschalter (105) im Betrieb auf gleiche Temperaturen erwärmen.

8. Treiberbaugruppe (100) nach einem der vorangehenden Ansprüche, **dadurch gekennzeichnet, dass** ferner eine Steuereinrichtung (205) zur Ansteuerung der Halbbrücken (305, 310, 315) vorgesehen ist, wobei die Steuereinrichtung (205) ferner dazu eingerichtet ist, Phasenspannungen oder Phasenströme des Synchronmotors (210) zu überwachen und den Synchronmotor (210) mittels der Phasentrenner (330) auszuschalten, falls die bestimmten Phasenspannungen oder Phasenströme auf einen Defekt eines der High-Side-Switches (320) oder eines der Low-Side-Switches (325) hinweisen.

## Claims

1. Driver assembly (100), wherein the driver assembly (100) comprises the following:
a predetermined number of semiconductor switches (105), wherein one of the semiconductor switches (105) is arranged inside a circle line (125) and the remaining semiconductor switches (105) are arranged on the circle line (125), **characterized in that** distances of the semiconductor switches (105) which are situated on the circle line (125) from the central semiconductor switch (105) are identical, and **in that** a total of nine semiconductor switches (105) are provided, the driver assembly (100) comprises three half-bridges (305, 310, 315) for actuating a three-phase synchronous motor (210) and
- each half-bridge (305, 310, 315) comprises three semiconductor switches (105) which are connected to one another as high-side switch (320), low-side switch (325) and phase separator (330);
- wherein the phase separator (330) is provided for connecting a centre tap between the high-side switch (320) and the low-side switch (325) to a phase connection (215, 220, 225) of the synchronous motor (210).

2. Driver assembly (100) according to Claim 1, **characterized in that** the semiconductor switches (105) which are situated on the circle line (125) are uniformly distributed.

3. Driver assembly (100) according to Claim 3, **characterized in that** the three semiconductor switches (105) of the phase separator (330) are arranged in a row and the three high-side switches (320) are arranged on one side of the row and the three low-side switches (325) are arranged on the other side of said row.

4. Driver assembly (100) according to one of the preceding claims, **characterized in that** the semiconductor switches (105) are surface-mountable components with identical pin assignments.

5. Driver assembly (100) according to one of the preceding claims, further comprising a heat sink (135) for bearing against the semiconductor switches (105).

6. Driver assembly (100) according to Claims 4 and 5, **characterized in that** the heat sink (135) comprises a projection (410) for bearing against an electrical connecting element (340), which is situated on the surface, between two semiconductor switches (105).

7. Driver assembly (100) according to Claim 6, **characterized in that** a plurality of projections (410) are provided between the semiconductor switches (105) in such a way that the semiconductor switches (105) heat up to identical temperatures during operation.

8. Driver assembly (100) according to one of the preceding claims, **characterized in that** a control device (205) is further provided for actuating the half-bridges (305, 310, 315), wherein the control device (205) is further designed to monitor phase voltages or phase currents of the synchronous motor (210) and to switch off the synchronous motor (210) by means of the phase separator (330) if the determined phase voltages or phase currents indicate a fault in one of the high-side switches (320) or one of the low-side switches (325).

## Revendications

1. Module pilote (100), le module pilote (100) comprenant : un nombre prédéterminé de commutateurs à semi-conducteur (105), l'un des commutateurs à semi-conducteur (105) étant disposé en dedans d'une ligne circulaire (125) et les commutateurs à semi-conducteur (105) restants étant disposés sur la ligne circulaire (125), **caractérisé en ce que** les distances entre les commutateurs à semi-conducteur (105) situés sur la ligne circulaire (125) et le commutateur à semi-conducteur central (105) sont les mêmes, et **en ce que** neuf commutateurs à semi-conducteur (105) sont en tout prévus, le module pilote (100) comprend trois demi-ponts (305, 310, 315) destinés à commander un moteur synchrone triphasé (210) et
- chaque demi-pont (305, 310, 315) comprend trois commutateurs à semi-conducteur (105) qui sont reliés entre eux en tant que commutateur côté haut (320), commutateur côté bas (325) et séparateur de phase (330) ;
- le séparateur de phases (330) étant prévu pour relier un branchement central, situé entre le commutateur côté haut (320) et le commutateur côté bas (325), à une borne de phase (215, 220, 225) du moteur synchrone (210).

2. Module pilote (100) selon la revendication 1, **caractérisé en ce que** les commutateurs à semi-conducteur (105) se trouvant sur la ligne circulaire (125) sont répartis de manière régulière.

3. Module pilote (100) selon la revendication 3, **caractérisé en ce que** les trois commutateurs à semi-conducteur (105) des séparateurs de phases (330) sont disposés en rangée et les trois commutateurs côté haut (320) sont disposés sur un côté de la rangée et les trois autres commutateurs côté bas (325) sont disposés de l'autre côté.

4. Module pilote (100) selon l'une des revendications précédentes, **caractérisé en ce que** les commutateurs à semi-conducteur (105) sont des composants qui ont les mêmes affectations de broches et qui peuvent montés en surface.

5. Module pilote (100) selon l'une des revendications précédentes, comprenant en outre un dissipateur thermique (135) destiné en venir en appui sur les commutateurs à semi-conducteur (105).

6. Module pilote (100) selon les revendications 4 et 5, **caractérisé en ce que** le dissipateur thermique (135) comprend une saillie (410) destinée à venir en appui sur un élément de liaison électrique (340), situé sur la surface, entre deux commutateurs à semi-conducteur (105) .

7. Module pilote (100) selon la revendication 6, **caractérisé en ce qu'**une pluralité de saillies (410) sont prévues entre les commutateurs à semi-conducteur (105) de telle sorte que les commutateurs à semi-conducteur (105) chauffent aux mêmes températures pendant le fonctionnement.

8. Module pilote (100) selon l'une des revendications précédentes, **caractérisé en ce qu'**un dispositif de commande (205) est également prévu pour commander les demi-ponts (305, 310, 315), le dispositif de commande (205) étant en outre conçu pour surveiller les tensions de phase ou les courants de phase du moteur synchrone (210) et pour couper le moteur synchrone (210) à l'aide de séparateurs de phases (330) si les tensions de phase ou les courants de phase déterminés indiquent une défaillance de l'un parmi le commutateur côté haut (320) ou le commutateur côté bas (325).
